# EUROPÄISCHE PATENTSCHRIFT

(11) **EP 2 207 758 B1**
(45) Veröffentlichungstag und Bekanntmachung des Hinweises auf die Patenterteilung: **30.08.2017**
(21) Anmeldenummer: 08839622.1
(22) Anmeldetag: 20.10.2008
(51) Int. Cl.: C04B 35/491, H01L 41/187, H01L 41/273, H01L 41/43, H01L 41/047

(54) **PIEZOKERAMISCHES VIELSCHICHTELEMENT**
PIEZOCERAMIC MULTI-LAYER ELEMENT
ÉLÉMENT MULTICOUCHE PIÉZOCÉRAMIQUE

(30) Priorität: 18.10.2007 DE 102007000523
(43) Veröffentlichungstag der Anmeldung: 21.07.2010
(73) Patentinhaber: CeramTec GmbH, 73207 Plochingen (DE)
(72) Erfinder: BINDIG, Reiner, 95463 Bindlach (DE); SCHREINER, Hans-Jürgen, 91233 Neunkirchen am Sand-rollhofen (DE)
(74) Vertreter: Uppena, Franz
(86) Internationale Anmeldenummer: PCT/EP2008/064123
(87) Internationale Veröffentlichungsnummer: WO 2009/050299

(56) Entgegenhaltungen:
- EP-A- 1 124 265
- DE-A1- 19 840 488
- DE-A1-102004 031 307
- DE-A1-102006 039 858
- JP-A- 2004 137 106
- JP-A- 2004 161 519
- JP-A- 2006 108 546
- US-A- 5 792 379
- US-A1- 2004 012 000
- US-B1- 6 808 649
- TEXIER N ET AL: "Powder process influence on the characteristics of Mn,W,Sb,Ni-doped PZT", JOURNAL OF THE EUROPEAN CERAMIC SOCIETY, ELSEVIER SCIENCE PUBLISHERS, BARKING, ESSEX, GB, vol. 21, no. 10-11, 1 January 2001 (2001-01-01), pages 1499-1502, XP027557192, ISSN: 0955-2219 [retrieved on 2001-01-01]

## Beschreibung

Die Erfindung betrifft einen Werkstoff zur Herstellung eines piezokeramischen Vielschichtelements, sowie ein Verfahren zur Herstellung des Vielschichtelements.

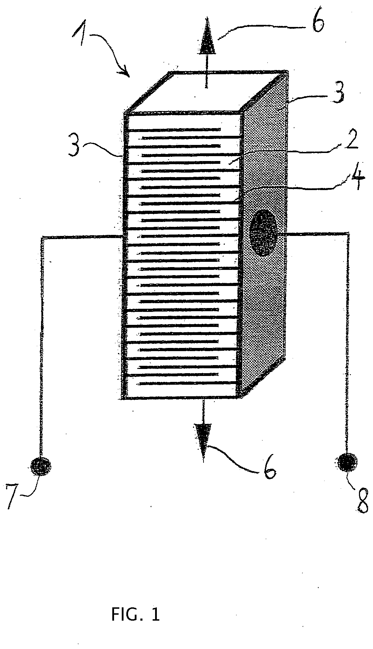

Ein piezokeramisches Vielschichtelement, wie es aus dem Stand der Technik bekannt ist, ist in der beigefügten Figur dargestellt. Ein Vielschichtelement 1 besteht aus gestapelten dünnen Schichten piezoelektrisch aktiven Werkstoffs 2, beispielsweise Blei-Zirkonat-Titanat (PZT), mit dazwischen angeordneten leitfähigen Innenelektroden 4, die alternierend an die Element-Oberfläche geführt werden. Außenelektroden 3 verbinden diese Innenelektroden 4. Dadurch werden die Innenelektroden 4 elektrisch parallel geschaltet und zu zwei Gruppen zusammengefasst, welche die beiden Anschlusspole 7 und 8 des Vielschichtelements 1 darstellen. Legt man eine elektrische Spannung an die Anschlusspole 7 und 8, so wird diese auf alle Innenelektroden 4 parallel übertragen und verursacht ein elektrisches Feld in allen Schichten des aktiven Werkstoffs, der sich dadurch mechanisch verformt. Die Summe aller dieser mechanischen Verformungen steht an den Endflächen des Elementes als nutzbare Dehnung 6 und/oder Kraft zur Verfügung.

Nach dem Stand der Technik werden piezokeramische Vielschichtelemente bei Temperaturen von etwa 1100 °C oder darüber in Luft gesintert. Deshalb kann als Innenelektrode nur ein Edelmetall mit hoher Schmelztemperatur verwendet werden. Unedle Metalle würden oxidieren. Normalerweise wird deshalb eine Silber-Palladiumlegierung mit bis zu 40 Gew.-% (Gewichtsprozent) Palladium verwendet. Dies ist jedoch mit hohen Werkstoffkosten verbunden. Niedrige Schmelztemperaturen des Innenelektroden-Werkstoffs erfordern aber auch einen Keramikwerkstoff mit entsprechend niedrigen Sintertemperaturen.

Die DE 102 004 031 307 A1 offenbart beispielsweise ein Verfahren zur Herstellung einer piezoelektrischen Materialzusammensetzung auf PZT Basis, wobei dem PZT Material zusätzlich Eisen oder eine Mischung aus Eisen und Silber zugegeben wird.

Die US 6,808,649 B1 offenbart eine piezoelektrische keramische Zusammensetzung, die bei weniger als 980 °C gesintert werden kann. Die keramische Zusammensetzung umfasst Bi₂O₃ und als Sinterhilfsmittel CdO, PbO oder LiF.

Die piezoelektrische keramische Zusammensetzung der US 5,792,379 A umfasst MnO₂ als Dotierungsmittel und einem Glasadditiv, welches u.a. Boroxid und Bismuthoxid enthält.

Als Zusätze für piezoelektrische keramische Zusammensetzung sieht die US 2004/0012000 A1 Fluorverbindungen, insbesondere MgFₑ und LiF vor, wobei zusätzlich Sinterhilfsmittel auch Cd oder Bi eingesetzt werden.

In der EP 1 124 265 A2 werden verschiedenen Seltenerdmetalle wie La oder Nd, Nebengruppenelemente wie Nb, Ta, Fe oder Ni, Alkalimetalle wie Na, K oder Li oder Erdalkalimetalle wie Sr als Dotierstoffe erwähnt, die außerdem die Diffusion von Silber inhibieren.

Die Absendung der Sintertemperatur der piezoelektrischen keramischen Zusammensetzung durch Zugabe von NiO wird von N. Texier et al. beschrieben (N. Texier, et al. Powder process influence on the characteristics of Mn, W, Sb, Nidoped PZT, Journal of the European Ceramic Society, 21 (2001), 1499-1502).

Verschiedene Sinterhilfsmittel wie PbO, SiO₂, Li₂O, GeO₂, MgO, und weitere Stoffe werden beispielsweise auch in der JP 2006/108546 A1 erwähnt. MnO₂ wird insbesondere in der JP 2004/161519 A als Hilfsmittel offenbart. Die JP 2004/137106 A offenbart zusätzlich NiO, Fe₂O₃, CuO und Sb₂O₃ als Hilfssubstanzen in der keramischen Zusammensetzung.

In der DE 10 2006 039 858 A1 wird ein monolithisches Biegeelement beschrieben, welches durch Sintern bei 900 °C Hergestellt wird. Als piezoelektrisches keramisches Material wird die in der DE 198 40 488 A1 beschriebene Keramik eingesetzt. Das in der DE 198 40 488 A1 offenbarte keramische Material kann dabei fünfwertiges Sb umfassen.

Der Erfindung liegt die Aufgabe zugrunde, die Nachteile des Standes der Technik zu beheben und die Kosten von piezokeramischen Vielschichtelementen zu reduzieren durch einen Keramikwerkstoff mit einer geringeren Sintertemperatur als üblich sowie Innenelektroden ohne Edelmetallanteil oder zumindest mit einem wesentlich geringeren Edelmetallanteil.

Die Lösung der Aufgabe erfolgt mit Hilfe eines Werkstoffs zur Herstellung eines piezokeramischen Vielschichtelements aus einem PZT-Werkstoff als Grundwerkstoff nach einem der Ansprüche 1 bis 3, und einem Verfahren zur Herstellung des Vielschichtelements nach Anspruch 4.

Vorteilhafte Ausgestaltungen der Erfindung werden in den abhängigen Ansprüchen beansprucht.

Silber wird in der nachfolgenden Beschreibung nicht als Edelmetall eingestuft, obwohl es elektrochemisch betrachtet zu den Edelmetallen gehört.

Das erfindungsgemäße Vielschichtelement enthält Innenelektroden, deren Hauptwerkstoffkomponente aus reinem Silber ohne sonstigen Edelmetallanteil besteht. Da Silber bei 961 °C schmilzt und diese Temperatur in Gegenwart von piezokeramischem Werkstoff noch weiter absinkt, sollte eine Sintertemperatur von 950 °C nicht überschritten werden. Erreicht werden kann dieses Ziel durch drei Maßnahmen:
a) Es muss eine bei niedrigen Temperaturen sinternde PZT-Keramik eingesetzt werden.
b) Der PZT- Werkstoff muss gegenüber der Eindiffusion von Silber beim Sintern robust sein. Das aus der Innenelektrode eindiffundierende Silber senkt die Sintertemperatur weiter beträchtlich ab. Es darf aber die piezomechanischen Eigenschaften des Werkstoffs möglichst wenig beeinflussen.
c) Die Innenelektrode muss durch Zusätze von PZT oder verwandten Keramikarten und/oder einer Metalllegierung und/oder Metalloxidmischung stabilisiert werden, da sie sonst weitgehend in die Keramik diffundiert, deren Eigenschaften verändert oder ihre Leitfähigkeit verliert.

Der erfindungsgemäße keramische Werkstoff besteht bevorzugt aus Blei-Zirkonat-Titanat, Bariumtitanat oder Wismuttitanat. Die Herabsetzung der Sintertemperatur wird dadurch erreicht, dass dem Grundwerkstoff PZT ein elektrisch nicht leitfähiges Sinterhilfsmittel zugegeben wird, dessen Konzentration in der Summe der Stoffe ≤ 5 Gew.-%, bevorzugt < 1 Gew.-%, besonders bevorzugt < 0,5 Gew.-%, beträgt.

Folgende Sinterhilfsmittel werden erfindungsgemäß eingesetzt:
Es werden Sinterhilfsmittel ausgewählt aus dreiwertigen Metalloxiden wie Al₂O₃, Mn₂O₃ oder Cr₂O₃.

Es werden Sinterhilfsmittel eingesetzt, die vierwertige Kationen enthalten, bevorzugt eingesetzt werden -InO₂, TlO₂ oder SnO₂.

Es werden Sinterhilfsmittel eingesetzt, die fünfwertige Kationen enthalten, bevorzugt eingesetzt werden P₂O₅, As₂O₅, oder Bi₂O₅.

Das Sinterhilfsmittel kann aus einem Stoff oder einer Kombination der vorgenannten Stoffe einer Gruppe oder einer Kombination der vorgenannten Stoffe der verschiedenen Gruppen bestehen.

Die Konzentration des Sinterhilfsmittels in der Summe der Stoffe ist ≤ 5 Gew.-%, bevorzugt < 2 Gew.-% und besonders bevorzugt < 1 Gew.-%.

Die Konzentration eines einzelnen Stoffs eines Sinterhilfsmittels ist ≤ 3 Gew.-%, bevorzugt < 1 Gew.-% und besonders bevorzugt < 0,5 Gew.-%.

Die Zugabe der Menge des Sinterhilfsmittels kann bereits in der Rezeptur berücksichtigt werden, wenn sie beim Mischen der Rohstoffe vor der Kalzination oder nach der Kalzination erfolgt.

Die Zugabe der Menge des Sinterhilfsmittels erfolgt durch Messen und Dotieren auf einen Zielwert, um damit Schwankungen der Rohstoffe und des Aufbereitungsverfahrens zu berücksichtigen.

Es kann auch eine Beschichtung mit flüssiger Zugabe des Sinterhilfsmittels vor oder nach dem Kalzinieren erfolgen.

Durch den erfindungsgemäßen PZT-Werkstoff ist es möglich, die Sintertemperatur auf unter 900 °C abzusenken und ein Vielschichtelement herzustellen, das die gleichen Eigenschaften besitzt wie ein edelmetallhaltiges Element nach dem Stand der Technik.

Bei einem erfindungsgemäßen monolithischen Vielschichtelement, das beispielsweise 1 bis 1000 Lagen piezoelektrisch aktiven Werkstoffs umfassen kann, besteht der erfindungsgemäße Werkstoff der Innenelektroden, die sich im aktiven Werkstoff befinden, aus Silber, vorzugsweise reinem Silber, dem zusätzlich ein elektrisch nicht leitfähiger Werkstoff mit einem Gewichtsanteil von 0 % bis maximal 30 %, bevorzugt weniger als 15 %, zugegeben werden kann. Das Silber der Innenelektroden liegt im Ausgangszustand vor dem Sintern als kugelförmige Partikel (Pulver) vor.

Als elektrisch nicht leitfähiger Werkstoff kann den Innenelektroden Blei-Titanat-Zirkonat (PZT), insbesondere aus einem kodotierten Werkstoff bestehend, mit einem Gewichtsanteil bis maximal 30 %, bevorzugt von 5% bis 15%, zugegeben werden.

Dem Werkstoff der Innenelektroden kann zusätzlich zu dem elektrisch nicht leitfähigen Werkstoff noch eine Metalllegierung und/oder eine Metalloxidmischung mit einem Anteil von nicht mehr als 30 Gew.-%, bevorzugt weniger als 10, besonders bevorzugt weniger als 5 Gew.-%, zugegeben werden. Der Anteil der beiden zugegebenen Stoffe kann damit insgesamt 60 Gew.-% betragen und die Stoffe können in einer beliebigen Zusammensetzung miteinander gemischt sein. Diese Metalllegierung und/oder Metalloxidmischung kann aber auch den Anteil des elektrisch nicht leitfähigen Werkstoffs ersetzen. Als Metalllegierung und/oder Metalloxidmischung kann Edelmetall verwendet werden mit Ausnahme von Silber. Die Metalllegierung und/oder Metalloxidmischung kann Palladium oder Platin enthalten. Zur Herstellung eines erfindungsgemäßen Vielschichtelements wird ein kalzinierter PZT-Werkstoff verwendet, beispielsweise entsprechend der Zusammensetzung 0,98Pb(Zr_{0,53}Ti_{0,47})O₃-0,02Sr(K_{0,25}Nb_{0,75})O₃, wie er aus der DE 19 840 488 A1 bekannt ist.

Die Herstellung eines erfindungsgemäßen Vielschichtelements wird an Hand eines allgemein möglichen Verfahrens näher erläutert. Zur Herstellung von Vielschichtelementen wird die Folientechnik angewandt. Die beschriebene Vorgehensweise und die beschriebenen Parameter geben nur ein Beispiel wieder. Dem Fachmann sind jederzeit ähnliche Vorgehensweisen und Parameter offensichtlich.

Der kalzinierte Ausgangswerkstoff wird vorzerkleinert und in einer Ringspaltkugelmühle auf eine mittlere Korngröße von beispielsweise 0,8 µm gemahlen.

Aus dem entstandenen Pulver wird ein Gießschlicker nach dem Stand der Technik aufbereitet, dabei werden als Sinterhilfsmittel definiert ein oder mehrere der oben genannten Stoffe zugegeben. Der Gießschlicker wird zu einer Endlosfolie gegossen, getrocknet und aufgerollt. Hierfür eignen sich beispielsweise Gießbänder, die nach dem Doctor-Blade-Verfahren arbeiten. Die Folie hat nach diesem Verfahren nach dem Trocknen eine Dicke von beispielsweise 70 µm und nach dem Sintern eine Dicke von 60 µm.

Die Folie wird in Abschnitte von ca. 200 x 200 mm zerteilt. Darauf werden die Innenelektrodenmuster aus Metallpaste mittels Siebdruck aufgedruckt. Durch die Form des Drucklayouts wird die spätere Abmessung des Vielschichtelements definiert.

Die Innenelektrodenpaste kann aus reinem Silberpulver oder beispielsweise aus einer Mischung von Silberpulver mit einem PZT-Pulver der oben formelmäßig vorgegebenen Zusammensetzung hergestellt werden. Zusätzlich kann eine Metalllegierung oder eine Metalloxidmischung der oben angegebenen Art zugegeben werden. Diese Metalllegierung oder Metalloxidmischung kann aber auch den Anteil des elektrisch nicht leitfähigen Werkstoffs ersetzen. Binder wie Ethylzellulose und Lösungsmittel wie Terpineol sorgen für die gute Druckbarkeit der Paste. Die Paste wird so aufgedruckt, dass die Dicke der Innenelektrode nach dem Sintern etwa 3 µm beträgt.

Die bedruckten und getrockneten Folienabschnitte werden so gestapelt, dass der Aufbau des Vielschichtelements entsteht.

Die gestapelten Folien werden nun nach dem Stand der Technik bei erhöhtem Druck und erhöhter Temperatur zu einem Laminat zusammengepresst.

Anschließend wird das Laminat in die durch das Drucklayout vorgegebenen Formen und die Anzahl der Vielschichtelemente getrennt, beispielsweise durch Sägen oder Stanzen.

Die Vielschichtelemente werden bei einer Temperatur von 500 °C von den organischen Binderanteilen befreit und anschließend bei 900 °C gesintert.

Die gesinterten Vielschichtelemente werden an den Schmalseiten geschliffen und für den Anschluss der Außenelektroden mit einer Grundmetallisierung bedruckt.

Durch Anlegen einer Spannung von 200 V werden die Vielschichtelemente nun so polarisiert, dass eine in einer Richtung durchgehende Polarisation entsteht.

Für ein erstes Referenzbeispiel werden Vielschichtelemente mit den Abmessungen 7 x 7 x 30 mm nach dem oben beschriebenen Verfahren unter der Zugabe von Phosphorpentoxid und Eisenoxid als Sinterhilfsmittel hergestellt. Die Zugabe wird so vorgenommen dass der Gehalt nach Analyse der ungesinterten Keramikfolie 200 ppm Phosphor und 0,4 % Eisen bezogen auf das Gewicht des Keramikfeststoffs beträgt. Als Innenelektroden-Werkstoff wird eine Mischung aus reinem Silberpulver, 90 Gew.-%, und fein gemahlenem PZT-Pulver, 10 Gew.-%, verwendet. Die Mischung wird mit Ethylcellulose und Terpineol zu einer Paste verrührt, die 50 % der Mischung enthält.

Die Vielschichtelemente werden bei 900 °C gesintert. Die Dicke der Keramikfolien beträgt nach dem Sintern 90 µm. Das Bauteil weist beim Anlegen von 200 V Betriebsspannung eine spezifische Dehnung von 1,4 Promille der Gesamtlänge und eine Blockierspannung von 40 N/mm² auf.

Für ein zweites Referenzbeispiel werden Vielschichtelemente mit den Abmessungen 7 x 7 x 30 mm nach dem oben beschriebenen Verfahren unter der Zugabe von Phosphorpentoxid und Eisenoxid als Sinterhilfsmittel hergestellt. Die Zugabe wird so vorgenommen, dass der Gehalt nach Analyse der ungesinterten Keramikfolie 200 ppm Phosphor und 0,4 % Eisen bezogen auf das Gewicht des Keramikfeststoffs beträgt.

Als Innenelektroden-Werkstoff wird eine Mischung aus reinem Silberpulver, 80 Gew.-%, und fein gemahlenem PZT-Pulver, 20 Gew.-%, verwendet. Die Mischung wird mit Ethylcellulose und Terpineol zu einer Paste verrührt, die 50 % der Mischung enthält.

Die Vielschichtelemente werden bei Temperaturen um 900 °C gesintert. Die Dicke der Keramikfolien beträgt nach dem Sintern 60 µm.

Das Bauteil weist beim Anlegen von 200 V Betriebsspannung eine spezifische Dehnung von 2,0 Promille der Gesamtlänge und eine Blockierspannung von 56 N/mm² auf.

Zum Vergleich werden Vielschichtelemente mit den Abmessungen 7 x 7 x 30 mm nach dem oben beschriebenen Verfahren, aber in der aus dem Stand der Technik bekannten Zusammensetzung, also ohne Zusatz von Sinterhilfsmitteln, hergestellt. Als Innenelektrodenwerkstoff wird eine handelsübliche Metallpaste mit der Zusammensetzung AgPd 70/30 im Metallanteil verwendet.

Die Vielschichtelemente werden bei Temperaturen um 1000 °C gesintert. Die Dicke der Keramikfolien beträgt nach dem Sintern 90 µm.

Das Bauteil weist beim Anlegen von 200 V Betriebsspannung eine spezifische Dehnung von 1,7 Promille der Gesamtlänge und eine Blockierspannung von 40 N/mm² auf.

Bei einem Vergleich der beiden Referenzbeispiele zeigt sich, dass die spezifische Dehnung der Vielschichtelemente etwa 80% der Dehnung von mit AgPd 70/30 Innenelektroden versehenen Standard-Vielschichtelementen beträgt. Gleichzeitig werden die Vielschichtelemente durch die Wirkung der Sinterhilfsmittel aber steifer und dichter, was an dem unveränderten Wert für die mechanische Blockierspannung und einer erheblich höheren elektrischen Durchschlagspannung sichtbar wird.

Es ist daher möglich, bei den Vielschichtelementen die Lagendicke zu verringern und dadurch bedingt bei gleicher Betriebsspannung die Betriebsfeldstärke im aktiven Werkstoff zu erhöhen und gleichwertige oder gar überlegene Vielschichtelemente zu erzeugen.

## Patentansprüche

1. Werkstoff zur Herstellung eines piezokeramischen Vielschichtelements aus einem PZT-Werkstoff als Grundwerkstoff, **dadurch gekennzeichnet, dass** dem Grundwerkstoff ein elektrisch nicht leitfähiges Sinterhilfsmittel zugegeben ist, wobei das elektrisch nicht leitfähige Sinterhilfsmittel ausgewählt ist aus dreiwertigen Metalloxiden, wobei die dreiwertigen Metalloxide ausgewählt sind aus Al₂O₃, Mn₂O₃ oder Cr₂O₃, oder wobei das elektrisch nicht leitfähige Sinterhilfsmittel vierwertige Kationen enthält, ausgewählt aus, InO₂, TlO₂ oder SnO₂, oder wobei das elektrisch nicht leitfähige Sinterhilfsmittel fünfwertige Kationen enthält, ausgewählt aus P₂O₅, As₂O₅, oder Bi₂O₅, oder wobei das elektrisch nicht leifähige Sinterhilfsmittel aus Kombinationen der genannten Sinterhilfsmittel besteht, und wobei eine Sintertemperatur des Werkstoffs zur Herstellung des piezokeramischen Vielschichtelements kleiner 900°C ist, wobei der Grundwerkstoff Blei-Zirkonat-Titanat ist.

2. Werkstoff nach Anspruch 1, **dadurch gekennzeichnet, dass** die Menge des Sinterhilfsmittels ≤ 5 Gew.-%, bevorzugt < 2 Gew.-% und besonders bevorzugt < 1 Gew.-% beträgt.

3. Werkstoff nach Anspruch 1 oder 2, **dadurch gekennzeichnet, dass** die Konzentrationen eines einzelnen Sinterhilfsmittels ≤ 3 Gew.-%, bevorzugt < 1 Gew.-% und besonders bevorzugt < 0,5 Gew.-% beträgt.

4. Verfahren zur Herstellung eines piezokeramischen Vielschichtelements aus einem Werkstoff nach einem der Ansprüche 1 bis 3, **dadurch gekennzeichnet, dass** ein kalzinierter PZT-Werkstoff als Grundwerkstoff gemahlen wird, dass aus dem Pulver ein Gießschlicker aufbereitet wird, dem ein Sinterhilfsmittel aus einem oder einer Kombination der Stoffe nach Anspruch 1 in einer Menge von ≤ 5 Gewichtsprozent hinzugegeben wird, dass der Gießschlicker anschließend zu einer Endlosfolie gegossen, vorzugsweise nach dem Doctor-Blade-Verfahren, getrocknet und in Folienabschnitte zerteilt wird, dass auf diese Folienabschnitte Innenelektrodenmuster aus Metallpaste mittels Siebdruck aufgedruckt mit der Metallpaste der Innenelektroden in Form deren Drucklayouts bedruckt werden, dass die bedruckten und getrockneten Folienabschnitte in einer solchen Anzahl gestapelt werden, dass der Aufbau des Vielschichtelements entsteht, dass die gestapelten Folien bei erhöhtem Druck und erhöhter Temperatur zu einem Laminat zusammengepresst werden, dass das Laminat in die durch das Drucklayout vorgegebenen Formen und die Anzahl der Vielschichtelemente, beispielsweise durch Sägen oder Stanzen, getrennt wird, dass die Vielschichtelemente bei einer Temperatur von 500°C von organischen Binderanteilen befreit und anschließend bei Temperaturen unter 900 °C gesintert werden.

## Claims

1. A material for producing a piezoceramic multi-layer element from a PZT material as a base material, **characterised in that** an electrically non-conductive sintering aid is added to the base material, wherein the electrically non-conductive sintering aid is selected from trivalent metal oxides, wherein the trivalent metal oxides are selected from Al₂O₃, Mn₂O₃ or Cr₂O₃, or wherein the electrically non-conductive sintering aid contains tetravalent cations selected from InO₂, TlO₂ or SnO₂, or wherein the electrically non-conductive sintering aid contains pentavalent cations selected from P₂O₅, As₂O₅ or Bi₂O₅, or wherein the electrically non-conductive sintering aid consists of combinations of the sintering aids mentioned, and wherein a sintering temperature of the material for the production of the piezoceramic multi-layer element is lower than 900°C, wherein the base material is lead zirconate titanate.

2. A material according to claim 1, **characterised in that** the quantity of the sintering aid amounts to ≤ 5 % by weight, preferably < 2 % by weight and particularly preferably < 1 % by weight.

3. A material according to claim 1 or 2, **characterised in that** the concentration of an individual sintering aid amounts to ≤ 3 % by weight, preferably < 1 % by weight and particularly preferably < 0.5 % by weight.

4. A method for producing a piezoceramic multi-layer element from a material according to one of claims 1 to 3, **characterised in that** a calcined PZT material is ground as the base material, **in that** from the powder there is prepared a castable slip to which a sintering aid consisting of one of or a combination of the substances according to claim 1 is added in a quantity of ≤ 5 % by weight, **in that** the castable slip subsequently is cast to form a continuous film, preferably according to the doctor-blade method, is dried and is divided into film sections, **in that** inner-electrode patterns of metal paste are printed on these film sections by means of screen-printing with the metal paste of the inner electrodes in the form of the print layout thereof, **in that** the film sections that have been printed on and dried are stacked in such a number that the structure of the multi-layer element develops, **in that** the stacked films are compressed at an elevated pressure and an elevated temperature to form a laminate, **in that** the laminate is separated into the forms, predetermined by the print layout, and the number of the multi-layer elements, for example by sawing or punching, **in that** the multi-layer elements are freed of organic binder portions at a temperature of 500°C and subsequently are sintered at temperatures below 900°C.

## Revendications

1. Matériau destiné à la production d'un élément multicouche piézocéramique à base d'un matériau PZT en tant que matériau de base, **caractérisé en ce qu'**au matériau de base est ajouté un adjuvant de frittage non électroconducteur, l'adjuvant de frittage non électroconducteur étant choisi parmi des oxydes métalliques trivalents, les oxydes métalliques trivalents étant choisis parmi Al₂O₃, Mn₂O₃ ou Cr₂O₃, ou l'adjuvant de frittage non électroconducteur contenant des cations tétravalents, choisis parmi InO₂, TiO₂ ou SnO₂, ou l'adjuvant de frittage non électroconducteur contenant des cations pentavalents, choisis parmi P₂O₅, As₂O₅ ou Bi₂O₅, ou l'adjuvant de frittage non électroconducteur consistant en des associations desdits adjuvants de frittage, et une température de frittage du matériau dans la production de l'élément multicouche piézocéramique étant inférieure à 900 °C, le matériau de base étant le titano-zirconate de plomb.

2. Matériau selon la revendication 1, **caractérisé en ce que** la quantité de l'adjuvant de frittage vaut ≤ 5 % en poids, de préférence < 2 % en poids et de façon particulièrement préférée < 1 % en poids.

3. Matériau selon la revendication 1 ou 2, **caractérisé en ce que** les concentrations d'un adjuvant de frittage individuel valent ≤ 3 % en poids, de préférence < 1 % en poids et de façon particulièrement préférée < 0,5 % en poids.

4. Procédé pour la production d'un élément multicouche piézocéramique à partir d'un matériau selon l'une quelconque des revendications 1 à 3, **caractérisé en ce qu'**on broie un matériau PZT calciné, en tant que matériau de base, **en ce qu'**on prépare à partir de la poudre une barbotine coulable, à laquelle on ajoute en une quantité de ≤ 5 pour cent en poids un adjuvant de frittage à base d'une substance ou d'une association des substances selon la revendication 1, **en ce qu'**ensuite on coule la barbotine coulable en un film continu, de préférence selon le procédé à la racle et on le divise en fragments de film, **en ce que** sur ces fragments de film on imprime par sérigraphie des motifs d'électrodes internes à base de pâte métallique, la pâte métallique des électrodes internes étant imprimée à la forme de leurs motifs d'impression, **en ce qu'**on empile les fragments de film imprimés et séchés, en un nombre tel qu'il en résulte la structure de l'élément multicouche, **en ce qu'**on presse ensemble sous une pression élevée et à une température élevée les films empilés, pour obtenir un stratifié, **en ce qu'**on divise le stratifié, par exemple par sciage ou découpage, en les formes préétablies par le motif d'impression et en le nombre des éléments multicouches, **en ce qu'**on libère les éléments multicouches des fractions de liants organiques à une température de 500 °C et ensuite on les soumet à un frittage à des températures inférieures à 900 °C.
